# EUROPEAN PATENT APPLICATION

(11) **EP 2 535 943 A1**
(43) Date of publication of application: **19.12.2012**
(21) Application number: 10845818.3
(22) Date of filing: 21.12.2010
(51) Int. Cl.: H01L 31/042

(54) **PHOTOVOLTAIC MODULE AND MANUFACTURING METHOD THEREOF**

(30) Priority: 09.02.2010 JP 2010026522
(71) Applicant: Fuji Electric Co., Ltd., Kawasaki-shi Kanagawa 210-9530 (JP)
(72) Inventor: YANASE, Hironori, Kawasaki-shi Kanagawa 210-9530 (JP); YOKOYAMA, Yasuhiro, Tokyo 141-0032 (JP)
(74) Representative: Appelt, Christian W.
(86) International application number: PCT/JP2010/072988
(87) International publication number: WO 2011/099228

(57) **Abstract**

An object of the invention is to provide a photovoltaic module, and a manufacturing method thereof, wherein reliability and insulation are increased, without insulation failure occurring between a photovoltaic cell and a rear surface support material, even when warping occurs in the photovoltaic cell during a laminate molding. The invention is a photovoltaic module 1 configured so that at least a first sealing material 5 and a rear surface support material 6 are stacked in that order on one surface side 2b of a photovoltaic cell 2, a through hole 8 is provided in the rear surface support material 6, and the electric output of the photovoltaic cell 2 is output to the exterior by an electric output wire 7 of the photovoltaic cell 2 being passed through the through hole 8, wherein an insulating material 10 is disposed between the photovoltaic cell 2 and the first sealing material 5 in a position corresponding to the through hole 8.

## Description

### Technical Field

The present invention relates to a photovoltaic module that generates power by utilizing solar light.

### Background Art

Among heretofore known photovoltaic modules, there are those wherein an uppermost surface on a light receiving surface side is covered with glass, and those wherein the uppermost surface is covered with a translucent film.

In a photovoltaic module wherein the light receiving surface side is covered with glass, a moisture resistant film is disposed on the non-light receiving surface side. The moisture resistant film is of a structure wherein a sealing material and an aluminum foil or polyester film are sandwiched by a weather resistant film.

Meanwhile, in a photovoltaic module wherein the light receiving surface side is covered with a translucent film, a method whereby the translucent film and a photovoltaic cell are affixed using a sealing material is typically employed. Herein, in a rooftop photovoltaic module, or the like, wherein it is necessary for the non-light receiving surface side to be rigid, a rear surface support material is disposed on the non-light receiving surface side (for example, Patent Document 1).
A metal sheet such as a steel sheet, an aluminum sheet, or a stainless steel sheet, carbon fiber, glass fiber reinforced plastic (FRP), a ceramic, glass, or the like, is used as the rear surface support material.

Fig. 12 is a plan view of a heretofore known photovoltaic module described in Patent Document 1. Fig. 13 is a sectional view along an A-A line in Fig. 12 before a laminate molding.

A heretofore known photovoltaic module 31 includes a photovoltaic cell 32. A front surface sealing material 33 and front surface protective material 34 are stacked in that order on a front surface (a light receiving surface) 32a of the photovoltaic cell 32. Also, a rear surface sealing material 35 and rear surface support material 36 are stacked in that order on a rear surface (a non-light receiving surface) 32b of the photovoltaic cell 32. As a configuration of extracting electric output in this kind of photovoltaic module 31, an output terminal take-out through hole 38 is provided in the rear surface support material 36. Then, an electric output wire 37 of the photovoltaic cell 32 extends to the exterior of the photovoltaic module 31 through the through hole 38. The through hole 38 is sealed with a through hole sealing material 39 after the electric output wire 37 has been passed through.

Meanwhile, another example of a heretofore known photovoltaic module is disclosed in Patent Document 2. In Patent Document 2, a front surface filling material and glass (a front surface protective material) are stacked in that order on the front surface of a photovoltaic cell. Also, a rear surface filling material and a rear surface support material (a back cover) are stacked in that order on the rear surface of the photovoltaic cell. Also, a matt member is disposed on the inner side of the rear surface support material in the position of an aperture portion of the rear surface support material.

### Related Art Documents

### Patent Documents

Patent Document 1: JP-A-2004-327698
Patent Document 2: JP-A-2001-102616

### Disclosure of the Invention

### Problems to be Solved by the Invention

However, with the configuration of Patent Document 1, the following kind of problem occurs when integrating the stacked members by pressuring while heating with a laminator.

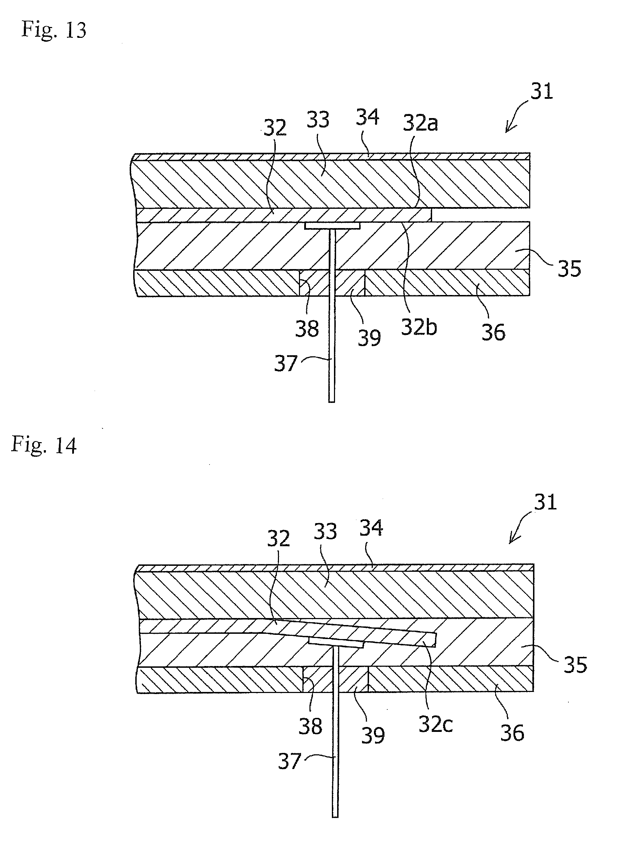

When carrying out a laminate molding, warping occurs in the photovoltaic cell 32 due to thermal stress, as shown in Fig. 14, and the rear surface sealing material 35 flows into the through hole 38. Because of this, an end portion 32c of the photovoltaic cell 32 comes closer to the rear surface support material 36, and the gap between the photovoltaic cell 32 and rear surface support material 36 becomes smaller. Consequently, when using a metal sheet for the rear surface support material 36, there is a problem in that insulation failure occurs between the photovoltaic cell 32 and rear surface support material 36 after a laminate molding.

The invention, having been contrived bearing in mind this kind of situation, has an object of providing a photovoltaic module, and a manufacturing method thereof, wherein reliability and insulation are increased, without insulation failure occurring between a photovoltaic cell and rear surface support material, even when warping occurs in the photovoltaic cell during a laminate molding.

### Means for Solving the Problems

In order to solve the problem of the heretofore known technology, the invention is a photovoltaic module configured so that at least a first sealing material and rear surface support material are stacked in that order on one surface side of a photovoltaic cell, a through hole is provided in the rear surface support material, and the electric output of the photovoltaic cell is output to the exterior by an electric output wire of the photovoltaic cell being passed through the through hole, wherein an insulating material is disposed between the photovoltaic cell and the first sealing material in a position corresponding to the through hole.

Also, according to the photovoltaic module of the invention, the insulating material is formed of a fluoride resin.

Also, according to the photovoltaic module of the invention, the insulating material is configured of a fluoride resin and a second sealing material, the fluoride resin is disposed between the first sealing material and second sealing material, and the second sealing material is affixed to the photovoltaic cell.

Also, according to the photovoltaic module of the invention, the photovoltaic cell, the first sealing material, the insulating material, and the rear surface support material are affixed by a laminate molding.

Also, according to the photovoltaic module of the invention, the width of the insulating material is two times or more larger than the through hole diameter of the through hole.

Also, according to the photovoltaic module of the invention, the thickness of the insulating material is a thickness within a range of 5µm to 1,000µm.

In order to solve the problem of the heretofore known technology, the invention is a manufacturing method of a photovoltaic module configured so that at least a first sealing material and rear surface support material are stacked in that order on one surface side of a photovoltaic cell, a through hole is provided in the rear surface support material, and the electric output of the photovoltaic cell is output to the exterior by an electric output wire of the photovoltaic cell being passed through the through hole, the method including a step of disposing an insulating material between the photovoltaic cell and first sealing material in a position corresponding to the through hole, and a step of affixing the photovoltaic cell, the insulating material, the first sealing material, and the rear surface support material by a laminate molding.

Also, according to the photovoltaic module manufacturing method of the invention, the insulating material is formed of a fluoride resin.

Also, according to the photovoltaic module manufacturing method of the invention, the insulating material is configured of a fluoride resin and a second sealing material, the method further including a step of disposing the fluoride resin between the first sealing material and second sealing material, and a step of affixing the second sealing material to the photovoltaic cell.

Also, according to the photovoltaic module manufacturing method of the invention, the width of the insulating material is two times or more larger than the through hole diameter of the through hole.

Also, according to the photovoltaic module manufacturing method of the invention, the thickness of the insulating material is a thickness within a range of 5µm to 1,000µm. Advantage of the Invention

According to the photovoltaic module according to the invention, since the insulating material is disposed between the photovoltaic cell and a first sealing material in a position corresponding to the through hole in the photovoltaic module, which is configured so that at least the first sealing material and rear surface support material are stacked in that order on one surface side of the photovoltaic cell, the through hole is provided in the rear surface support material, and the electric output of the photovoltaic cell is output to the exterior by the electric output wire of the photovoltaic cell being passed through the through hole, insulation is ensured by the insulating material being interposed between the photovoltaic cell and rear surface support material, even when an end portion of the photovoltaic cell is pressed downward when laminate molding. In particular, when using a metal sheet for the rear surface support material, it is possible to prevent an insulation failure between the photovoltaic cell and rear surface sealing material, even when the first sealing material becomes thin in the periphery of the through hole.

Also, according to the photovoltaic module according to the invention, since the width of the insulating material is two times or more larger than the through hole diameter of the through hole, insulation is ensured by the insulating material being reliably interposed between the photovoltaic cell and rear surface support material, even when the first sealing material melts when laminate molding.

Also, according to the photovoltaic module according to the invention, since the thickness of the insulating material is a thickness within the range of 5µm to 1,000µm, it is also possible to carry out a release of air from between the first sealing material and insulating material when laminate molding, while maintaining the insulating effect.

### Brief Description of the Drawings

[Fig. 1] Fig. 1 is a plan view of a photovoltaic module according to an embodiment of the invention.
[Fig. 2] Fig. 2 is a sectional view along an A-A line in Fig. 1.
[Fig. 3] Fig. 3 is a sectional view of an insulating material according to another embodiment of the invention.
[Fig. 4] Fig. 4 is an exploded perspective view showing the stacking disposition of each member according to a method of manufacturing the photovoltaic module according to the embodiments of the invention.
[Fig. 5] Fig. 5 is a sectional view showing the stacking disposition of each member according to the method of manufacturing the photovoltaic module according to the embodiments of the invention.
[Fig. 6] Fig. 6 is a schematic plan view showing a structure of an attachment of an electric output wire to a photovoltaic cell.
[Fig. 7] Fig. 7 is a schematic plan view showing a connection structure of the photovoltaic module wherein a plurality of photovoltaic cells are disposed in series.
[Fig. 8] Fig. 8 is an exploded perspective view showing the stacking disposition of each member according to the method of manufacturing the photovoltaic module according to the embodiments of the invention.
[Fig. 9] Fig. 9, being a sectional view according to the method of manufacturing the photovoltaic module according to the embodiments of the invention, is a sectional view of the photovoltaic module before a laminate molding.
[Fig. 10] Fig. 10, being a sectional view according to the method of manufacturing the photovoltaic module according to the embodiments of the invention, is a sectional view of the photovoltaic module after the laminate molding.
[Fig. 11] Fig. 11 is a sectional view along the A-A line in Fig. 1 after the laminate molding.
[Fig. 12] Fig. 12 is a plan view of a heretofore known photovoltaic module.
[Fig. 13] Fig. 13 is a sectional view along an A-A line in Fig. 12 before a laminate molding.
[Fig. 14] Fig. 14 is a sectional view along the A-A line in Fig. 12 after the laminate molding.

### Best Modes for Carrying Out the Invention

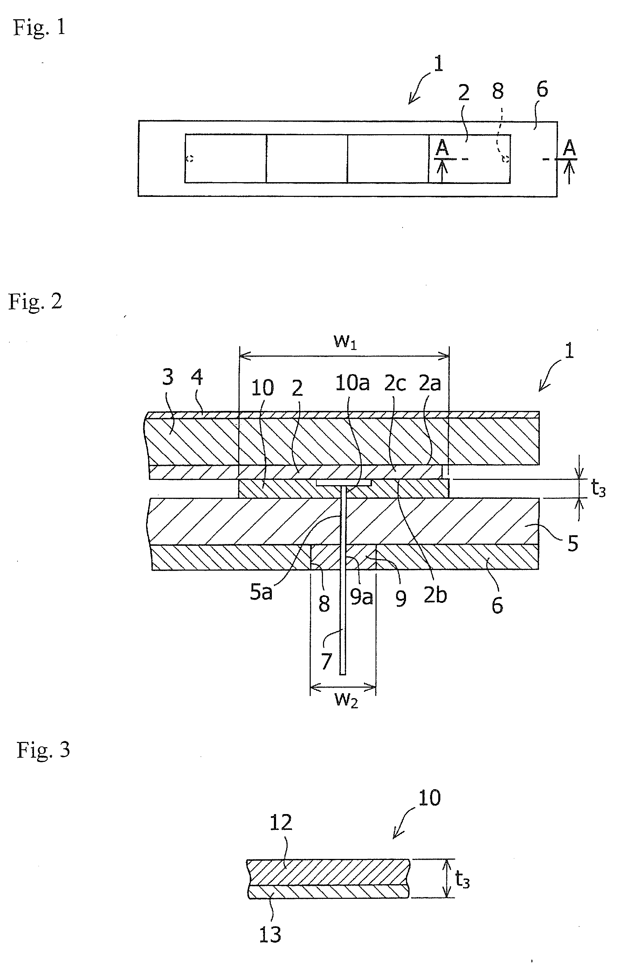

Hereafter, a description will be given, while referring to the drawings, of a photovoltaic module according to embodiments of the invention. Fig. 1 is a plan view of the photovoltaic module according to an embodiment of the invention. Fig. 2 is a sectional view along an A-A line in Fig. 1 before a laminate molding.

As shown in Fig. 1, the photovoltaic module 1 according to the embodiment includes a photovoltaic cell 2. As shown in Fig. 2, a front surface sealing material 3 and front surface protective material 4 are stacked in order from the photovoltaic cell 2 side on a front surface (that is, a light receiving surface) 2a of the photovoltaic cell 2. Also, a rear surface sealing material (a first sealing material) 5 and rear surface support material 6 are stacked in order from the photovoltaic cell 2 side on a rear surface (that is, a non-light receiving surface) 2b of the photovoltaic cell 2. Then, an electric output wire 7 extends from the photovoltaic cell 2 to the exterior of the photovoltaic module 1.
With this kind of configuration, the photovoltaic module 1 is configured so that the electric output of the photovoltaic cell 2 is output to the exterior.

As shown in Fig. 2, a through hole 8 for the electric output wire 7 to pass through is provided in the rear surface support material 6. A through hole sealing material 9 for sealing the through hole 8 is disposed in the through hole 8. The thickness of the through hole sealing material 9 is larger than the thickness of the rear surface support material 6.

A characteristic of the invention is that an insulating material 10 is disposed between the photovoltaic cell 2 and the rear surface sealing material 5 in a position corresponding to the through hole 8. A first slit 10a for the electric output wire 7 to pass through is provided in the insulating material 10. Also, a second slit 5a for the electric output wire 7 to pass through is also provided in the rear surface sealing material 5. Furthermore, a wire through hole 9a for the electric output wire 7 to pass through is provided in the through hole sealing material 9.
In the embodiment, the electric output wire 7 extends to the exterior of the photovoltaic module 1 through the first slit 10a of the insulating material 10, the second slit 5a of the rear surface sealing material 5, and the wire through hole 9a of the through hole sealing material 9. Also, the electric output wire 7 is connected to the photovoltaic cell 2 using a conductor such as a solder.

Next, a detailed description will be given of the front surface protective material 4, photovoltaic cell 2, sealing materials (front surface sealing material 3, rear surface sealing material 5, and through hole sealing material 9), rear surface support material 6, and electric output wire 7 used in the photovoltaic module 1.

A fluoride resin film of an ethylene tetrafluoroethylene copolymer (ETFE), polytetrafluoroethylene, a tetrafluoroethylene-perfluoroalkoxy vinyl ether copolymer, a tetrafluoroethylene-hexafluoropropylene copolymer, polychlorotrifluoroethylene, a chlorotrifluoroethylene-ethylene copolymer, polyvinyl fluoride, polyvinylidene fluoride, or the like, can be used as the front surface protective material 4 of the embodiment. It is preferable that surfaces where the front surface protective material 4 and front surface sealing material 3 are joined are subjected to a surface oxidization process, such as a corona discharge process or a plasma polymerization process.

A transparent resin such as an ethylene vinyl acetate copolymer, silane-modified polyethylene (silane-modified PE), polyvinyl butyral, a silicone resin, an epoxy resin, or a fluorinated polyimide can be used as the sealing materials (front surface sealing material 3, rear surface sealing material 5, and through hole sealing material 9) of the embodiment. The sealing materials 3, 5, and 9 can be cross-linked by adding a cross-linking agent. Also, in order to suppress photo-deterioration, it is preferable that an ultraviolet absorbing agent and a light stabilizer are included in the sealing materials 3, 5, and 9.

Herein, it not being absolutely necessary that the rear surface sealing material 5 and through hole sealing material 9 are transparent, colored materials may also be used. It is preferable that a laminated film or sheet, laminated and affixed in advance, is used for the front surface protective material 4 and front surface sealing material 3 disposed on the front surface (light receiving surface) 2a of the photovoltaic cell 2.

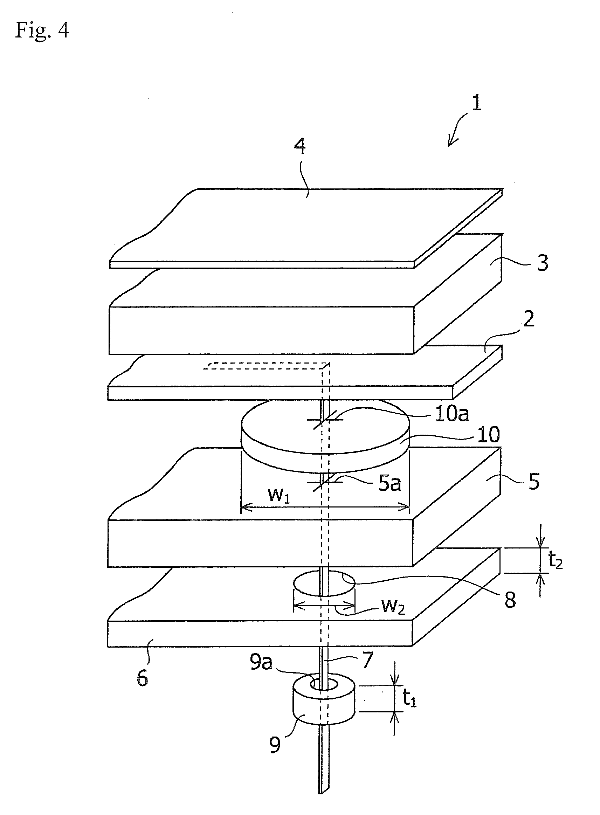

Also, it is preferable that a thickness t₁ of the through hole sealing material 9 of the embodiment is within a range from "a thickness the same as a thickness t₂ of the rear surface support material 6" to "1.5 times the thickness t₂ of the rear surface support material 6" (refer to Fig. 4). When the thickness t₁ of the through hole sealing material 9 is less than the thickness t₂ of the rear surface support material 6, the rear surface sealing material 5 flows into the through hole 8 when laminate molding, and an end portion 2c of the photovoltaic cell 2 is pressed downward. Because of this, the end portion 2c of the photovoltaic cell 2 comes closer to the rear surface support material 6, and it is no longer possible to ensure a dielectric breakdown voltage between the photovoltaic cell 2 and rear surface support material 6.
Also, when the thickness t₁ of the through hole sealing material 9 is more than 1.5 times the thickness t₂ of the rear surface support material 6, the through hole sealing material 9 pushes the front surface sealing material 3 up via the rear surface sealing material 5 when laminate molding. Because of this, the front surface sealing material 3 in a position corresponding to the through hole 8 becomes thinner, and it is no longer possible to ensure a dielectric breakdown voltage between the photovoltaic cell 2 and front surface protective material 4.

Furthermore, it is preferable that the diameter of the through hole sealing material 9 is within a range from a length the same as the through hole diameter of the through hole 8 to the through hole diameter of the through hole 8 - 1mm. This is because, when the diameter of the through hole sealing material 9 is larger than the through hole diameter of the through hole 8, the melted through hole sealing material 9 is liable to overflow onto the rear surface support material 6 when laminate molding, spoiling the external appearance.
Also, when the diameter of the through hole sealing material 9 is smaller than "the through hole diameter - 1mm", the rear surface sealing material 5 flows into the through hole 8, and the end portion 2c of the photovoltaic cell 2 is pressed downward. Because of this, the end portion 2c of the photovoltaic cell 2 comes closer to the rear surface support material 6, and it is no longer possible to ensure a dielectric breakdown voltage between the photovoltaic cell 2 and rear surface support material 6.

There being no particular restriction, a single crystal material semiconductor p-n junction, a non-single crystal material p-i-n junction, a semiconductor junction such as a Schottky junction, or the like, is used as the photovoltaic cell 2 of the embodiment. A silicon series compound is used as a semiconductor material. The photovoltaic cell 2 is preferably configured of a flexible material, and particularly preferably is an amorphous silicon (a-Si) semiconductor or compound semiconductor formed on a stainless steel substrate or polyimide film substrate.

It is preferable, in terms of dielectric breakdown voltage, heat resistance, and weather resistance, that the insulating material 10 of the embodiment is a fluoride resin. A single film of polyester, a polyimide, cellulose diacetate, cellulose triacetate, or the like, can be used as the insulating material 10.

Also, as another embodiment, it is possible to use a laminated film or sheet wherein an insulating film sealing material (a second sealing material) 12 and a fluoride resin 13 are stacked one on the other as the insulating material 10, as shown in Fig. 3. In this embodiment, the insulating film sealing material 12 is disposed on the fluoride resin 13. Consequently, the fluoride resin 13 is disposed between the rear surface sealing material 5 and the insulating film sealing material 12. Also, in this embodiment, the insulating film sealing material 12 is laminated and affixed in advance on the fluoride resin 13.

It is sufficient that a thickness t₃ of the insulating material 10 is in the region of 5µm to 1,000µm, and more preferable that the thickness t₃ is in the region of 25µm to 600µm. This is because, when the thickness t₃ of the insulating material 10 is 5µm smaller, the dielectric breakdown voltage is too low, meaning that the insulating effect is poor. Also, it is because, when the thickness t₃ of the insulating material 10 is more than 1,000µm, it is difficult to expel air from between the insulating material 10 and the rear surface sealing material 5 when laminate molding.

Also, it is sufficient that a width (diameter when the insulating material 10 is circular) w₁ of the insulating material 10 is two times or more larger than a through hole diameter w₂ of the through hole. When the width w₁ of the insulating material 10 is less than two times the through hole diameter w₂, an end portion of the insulating material 10 is pressed downward when the rear surface sealing material 5 melts when laminate molding. This is because the end portion 2c of the photovoltaic cell 2 comes closer to the rear surface support material 6, and it is no longer possible to ensure a dielectric breakdown voltage.

A fluoride resin film of an ethylene tetrafluoroethylene copolymer, polytetrafluoroethylene, a tetrafluoroethylene-perfluoroalkoxy vinyl ether copolymer, a tetrafluoroethylene-hexafluoropropylene copolymer, polychlorotrifluoroethylene, a chlorotrifluoroethylene-ethylene copolymer, polyvinyl fluoride, polyvinylidene fluoride, or the like, can be used as the fluoride resin used in the insulating material 10.
Also, a polyester film of polyethylene terephthalate, polybutylene terephthalate, polyethylene naphthalate, polytrimethylene terephthalate, polybutylene naphthalate, or the like, can be used as the polyester of the insulating material 10.

Also, a transparent resin such as an ethylene vinyl acetate copolymer, silane-modified polyethylene (silane-modified PE), polyvinyl butyral, a silicone resin, an epoxy resin, or a fluorinated polyimide can be used as the insulating film sealing material 12, in order to affix the insulating film sealing material 12 to the photovoltaic cell 2.
The insulating film sealing material 12 can be cross-linked by adding a cross-linking agent. Also, in order to suppress photo-deterioration, it is preferable that an ultraviolet absorbing agent and a light stabilizer are included in the insulating film sealing material 12. It not being absolutely necessary that the insulating film sealing material 12 is transparent, a colored material may also be used. Furthermore, there being no particular restriction, it is possible to use a silicone resin, an epoxy resin, a polyurethane resin, or the like, as an adhesive for affixing the photovoltaic cell 2 and insulating material 10.

It is possible to use a metal sheet, such as a hot-dip galvanized steel sheet, Galvalume steel sheet, aluminum sheet, or stainless steel sheet, a plastic sheet, an FRP sheet, or the like, as the rear surface support material 6 of the embodiment.

Also, a wire of a metal such as copper, aluminum, stainless steel, or nickel, and preferably of a foil form covered with solder without the metal surface being exposed, is preferable as the electric output wire 7 of the embodiment.

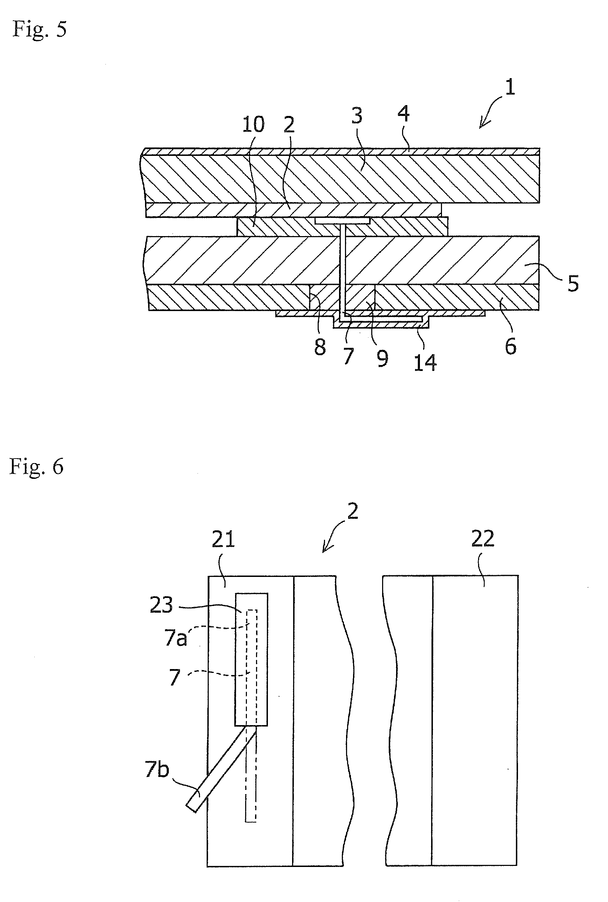

Next, a description will be given of the stacking disposition of each member when manufacturing the photovoltaic module 1. Fig. 4 is an exploded perspective view showing the stacking disposition of each member according to a method of manufacturing the photovoltaic module according to the embodiments of the invention. Fig. 5 is a sectional view showing the stacking disposition of each member according to the method of manufacturing the photovoltaic module according to the embodiments of the invention.

As shown in Figs. 4 and 5, when manufacturing the photovoltaic module 1, the front surface sealing material 3 and front surface protective material 4 are disposed on the light receiving side of the photovoltaic cell 2. Also, the insulating material 10, rear surface sealing material 5, and rear surface support material 6 are disposed on the non-light receiving side of the photovoltaic cell 2.
The electric output wire 7 is connected to the photovoltaic cell 2 via a conductor. The electric output wire 7 extends to the exterior of the photovoltaic module 1 through the first slit 10a of the insulating material 10, the second slit 5a of the rear surface sealing material 5, and the through hole 8 of the rear surface support material 6.

As shown in Fig. 5, when laminate molding the photovoltaic module 1, a temporary fixing adhesive tape 14 is attached so as to cover the through hole 8 in order to prevent the melted through hole sealing material 9 from overflowing from the through hole 8 of the rear surface support material 6. Laminate molding is carried out in this condition.

Next, a description will be given of a specific method of manufacturing the photovoltaic module 1 of the invention.

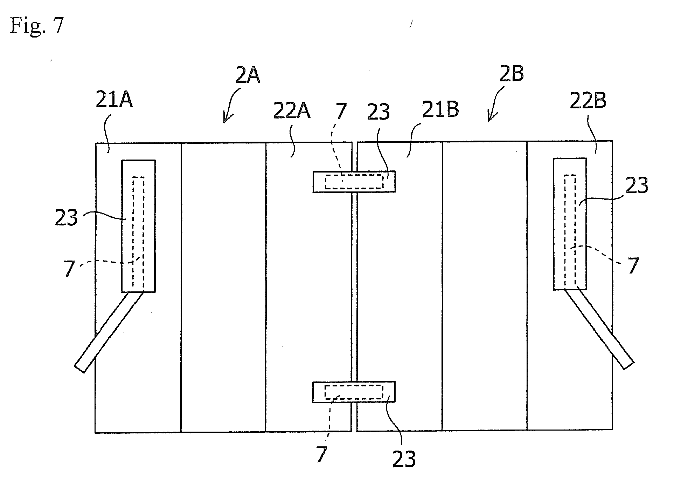

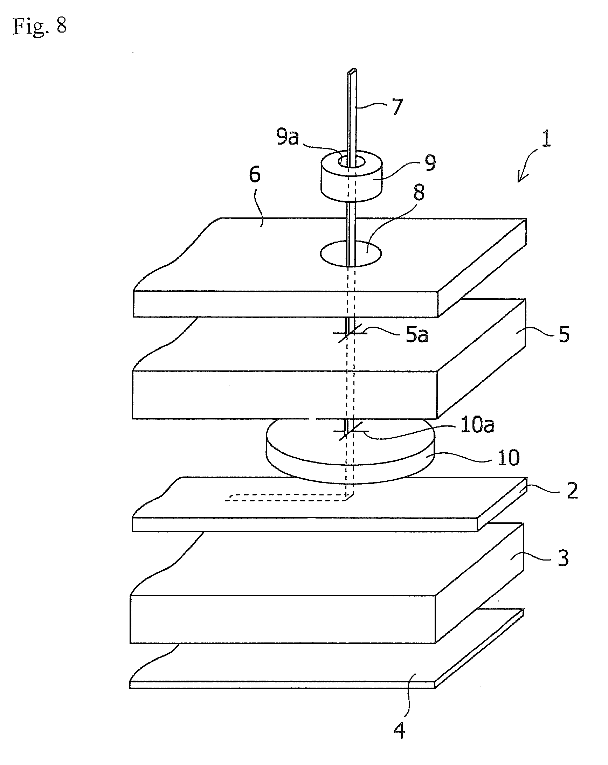

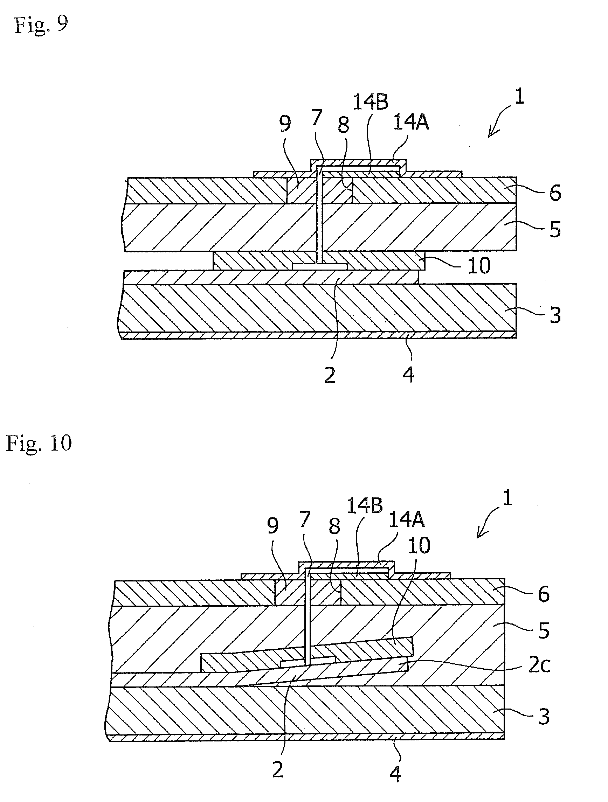

Fig. 6 is a schematic plan view showing a structure of an attachment of the electric output wire to the photovoltaic cell. Fig. 7 is a schematic plan view showing a connection structure of the photovoltaic module wherein a plurality of photovoltaic cells are disposed in series. Fig. 8 is an exploded perspective view showing the stacking disposition of each member according to the method of manufacturing the photovoltaic module according to the embodiments of the invention. Fig. 9 is a sectional view of the photovoltaic module before a laminate molding.

The photovoltaic module 1 of this embodiment uses the a-Si photovoltaic cell 2 fabricated on a film substrate. Also, a Galvalume steel sheet is used as the rear surface support material 6.

A polyimide film substrate with a thickness of 0.05mm is used as the film substrate a-Si photovoltaic cell 2. A plurality of photovoltaic elements are connected in series on one surface of the substrate. Also, as shown in Fig. 6, a positive take-out electrode 21 and negative take-out electrode 22 are formed on the non-light receiving surface side, which is the other surface of the substrate.

Firstly, ethylene-tetrafluoroethylene (ETFE) with a thickness of 0.025mm is used as the front surface protective material 4, the ETFE being unrolled from a rolled film, and cut to a predetermined size.
Next, silane-modified polyethylene with a thickness of 0.04mm is unrolled from a rolled film, and cut to a predetermined size as the front surface sealing material 3. Then, as shown in Fig. 8, the front surface sealing material 3 is disposed on the front surface protective material 4. The front surface protective material 4 and front surface sealing material 3 are stacked one on the other and affixed in advance, forming an ETFE/silane-modified polyethylene (silane-modified PE) laminate film. By so doing, it is possible to simplify the manufacturing process.

The electric output wire 7 is formed of copper foil covered with solder, wherein the thickness of the copper foil is 0.1mm, and the width of the copper foil is 2mm. When manufacturing the film substrate a-Si photovoltaic cell 2, one portion 7a of the electric output wire 7 is fixed in advance on the terminal take out positive take-out electrode 21 using a conductive adhesive tape 23 with a width of 8mm, as shown in Fig. 6.
Also, as shown in Fig. 6, another portion 7b of the electric output wire 7 is bent perpendicularly to the film substrate a-Si photovoltaic cell 2 in a position corresponding to the through hole. Although not shown in the drawing, processes of fixing and bending the electric output wire 7 are also carried out in the same way with respect to the negative take-out electrode 22.

As shown in Fig. 8, the heretofore described kind of film substrate a-Si photovoltaic cell 2 is disposed with the light receiving surface facing downward on the front surface sealing material 3.

Herein, a description will be given of a case of manufacturing a photovoltaic module wherein pluralities of photovoltaic cells 2A and 2B are disposed in series.
As shown in Fig. 7, the electric output wire 7 is attached, using the same method as that previously described, onto a positive take-out electrode 21A of the photovoltaic cell 2A on the extreme positive side, and onto a negative take-out electrode 22B of the photovoltaic cell 2B on the extreme negative side.
After disposing the photovoltaic cells 2A and 2B in parallel, the electric output wire (copper foil covered with solder) 7 is disposed so as to bridge a negative take-out electrode 22A and positive take-out electrode 21B between adjacent photovoltaic cells 2A and 2B. The whole surface of the electric output wire 7 is covered using the conductive adhesive tape 23, and the electric output wire 7 is thus fixed to the negative take-out electrode 22A and positive take-out electrode 21B.

As shown in Fig. 8, the insulating material 10 is disposed in a position corresponding to the through hole 8 on the film substrate a-Si photovoltaic cell 2. The ETFE with a thickness of 0.025mm used as the front surface protective material 4 and the silane-modified PE film with a thickness of 0.4mm used as the front surface sealing material 3 are cut out to a diameter of 28mm, and used for the insulating material 10.
The insulating material 10 is formed by stacking and affixing, in advance, the ETFE/silane-modified PE laminate film used for the front surface protective material 4 and front surface sealing material 3. By so doing, it is possible to simplify the manufacturing process. Also, stacking and affixing in this way is also preferable in terms of reliability.

As shown in Fig. 8, the first slit 10a with a length of 20mm is formed in a cross form in the insulating material 10 in a position corresponding to the terminal take-out portion of the electric output wire 7. The first slit 10a of the insulating material 10 is fabricated in advance by applying a blade on a flat plate. The electric output wire 7 of the photovoltaic cell 2 is disposed on the non-light receiving surface side of the photovoltaic cell 2 through the first slit 10a.

A silane-modified PE film with a thickness of 0.4mm is unrolled from a rolled film, and used as the rear surface sealing material 5. The second slit 5a with a length of 80mm is formed in the rear surface sealing material 5 in a position corresponding to the terminal take-out portion. The second slit 5a of the rear surface sealing material 5 is fabricated in advance by applying a blade on a flat plate. The electric output wire 7 of the photovoltaic cell 2 is disposed on the non-light receiving surface side of the photovoltaic cell 2 through the first slit 10a of the insulating material 10 and the second slit 5a of the rear surface sealing material 5.

A fluoride resin coated Galvalume steel sheet (Nippon Steel and Sumikin Coated Sheet Corporation' s Sunfron 20GL Cool) with a width of 0.8mm is used for the rear surface support material 6. As shown in Figs. 8 and 9, the steel sheet is cut in advance to a predetermined size, and the through hole 8 with a diameter of 10mm is provided in a position corresponding to the terminal take-out portion. Also, in order to improve adhesiveness with the rear surface sealing material 6, an acrylic resin series electrodeposition coating aluminum primer (Momentive Performance Materials Inc.'s Tosprime New F) is applied in advance to the front surface of the steel plate. The primer is applied to a thickness of in the region of 1µm using a roll coater on a flat plate, and allowed to dry for 30 minutes or more at room temperature.

A silane-modified PE film with a thickness of 0.4mm is used as the through hole sealing material 9. The film is used after cutting out to a diameter of 9.5mm. As shown in Fig. 8, the wire through hole 9a with a diameter of 5mm for the electric output wire 7 to pass through is provided in the center of the through hole sealing material 9. The wire through hole 9a of the through hole sealing material 9 is fabricated in advance by applying a blade on a flat plate, and cutting out the through hole sealing material 9.
The through hole sealing material 9 is disposed in two stacked layers in the through hole 8 of the rear surface support material 6. At this time, the electric output wire 7 of the photovoltaic cell 2 is disposed so as to penetrate the wire through hole 9a of the through hole sealing material 9.

Also, as shown in Fig. 9, fluoride resin temporary fixing adhesive tapes 14A and 14B with a thickness of 0.08mm and a width of 13mm are attached as far as the position of the electric output wire 7 coming out of the through hole 8 of the rear surface support material 6. That is, as shown in Fig. 9, each of the adhesive tapes 14A and 14B is disposed so as to cover a half of the through hole 8, with the electric output wire 7 as a border. By so doing, the whole of the exposed surface of the through hole sealing material 9 in the through hole 8 is covered with the adhesive tapes 14A and 14B. Also, the electric output wire 7 coming out of the through hole 8 is bent in the direction in which the fluoride resin adhesive tape 14B is attached. Then, the electric output wire 7 is attached onto the fluoride resin adhesive tape 14B using the fluoride resin adhesive tape 14A.

Finally, a laminate molding of the members disposed stacked as in Fig. 9 is carried out using a vacuum thermocompression method. The laminate molding is carried out using a method whereby vacuum thermocompression is performed at a temperature of 140°C to 150°C for 5 minutes to 25 minutes.

Fig. 10 shows a sectional view of the photovoltaic module 1 after the laminate molding.
Before the laminate molding, as shown in Fig. 9, there is a space formed by the insulating material 10 between the front surface sealing material 3 and rear surface sealing material 5. When carrying out the laminate molding in this condition, the front surface sealing material 3 and rear surface sealing material 5 melt, and the front surface sealing material 3 and rear surface sealing material 5 come into close contact with the insulating material 10, as shown in Fig. 10. Because of this, the space between the front surface sealing material 3 and rear surface sealing material 5 is hermetically closed.

After the laminate molding, the fluoride resin temporary fixing adhesive tapes 14A and 14B are removed. At this time, a terminal box with distribution cable (not shown) is affixed to the front surface of the rear surface support material 6 using a one component moisture curable silicone resin (Shin-Etsu Chemical Co., Ltd.'s KE-45T). Herein, the terminal box is formed of modified polyphenylene ether (SABIC Innovative Plastics Japan's Noryl PX9406).

Also, the electric output wire 7 is soldered to the terminal block of the terminal box. A two component curable silicone resin (Shin-Etsu Chemical Co., Ltd.'s KE-200/CX-200) is used as an insulating sealing material of the portion to which the electric output wire 7 is attached. The insulating sealing material is injected into the wiring portion of the electric output wire 7, and a cover is attached to the terminal box.
The photovoltaic module 1 is manufactured in accordance with the heretofore described kind of flow.

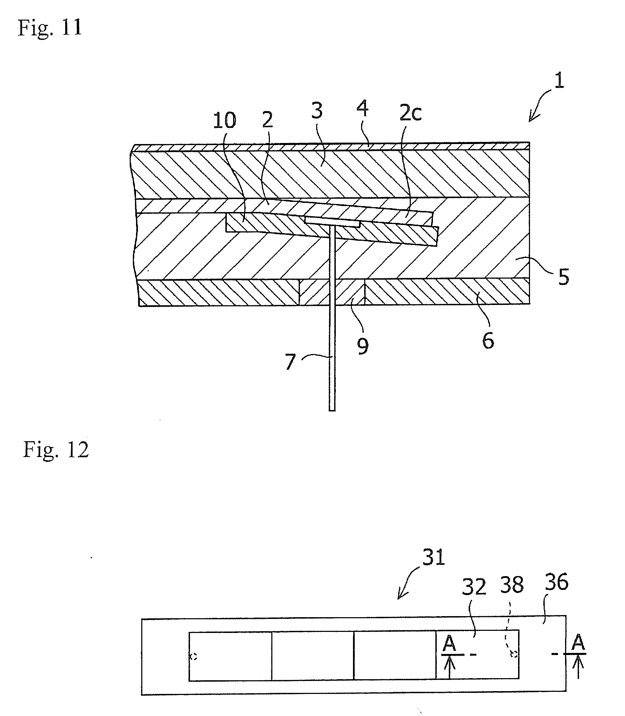

Fig. 11 is a sectional view along the A-A line in Fig. 1 after the laminate molding.
Before the laminate molding, as shown in Fig. 1, a space is formed by the insulating material 10 between the front surface sealing material 3 and rear surface sealing material 5. When carrying out the laminate molding in this condition, the front surface sealing material 3 and rear surface sealing material 5 melt, and the front surface sealing material 3 and rear surface sealing material 5 come into close contact with the insulating material 10, as shown in Fig. 11. Because of this, the space between the front surface sealing material 3 and rear surface sealing material 5 is hermetically closed. Also, according to this embodiment, even when the end portion 2c of the photovoltaic cell 2 is pressed downward after the laminate molding, as shown in Fig. 11, insulation is ensured by the insulating material 10 being interposed between the photovoltaic cell 2 and rear surface support material 6.

According to the photovoltaic module 1 according to this embodiment, since the insulating material 10 is disposed between the photovoltaic cell 2 and rear surface sealing material 5 in a position corresponding to the through hole 8 in the photovoltaic module 1, which is configured so that the rear surface sealing material 5 and rear surface support material 6 are stacked in that order on the rear surface 2b of the photovoltaic cell 2, the through hole 8 is provided in the rear surface support material 6, and the electric output of the photovoltaic cell 2 is output to the exterior by the electric output wire 7 of the photovoltaic cell 2 being passed through the through hole 8, insulation is ensured by the insulating material 10 being interposed between the photovoltaic cell 2 and rear surface support material 6, even when the end portion 2c of the photovoltaic cell 2 is pressed downward when laminate molding. In particular, when using a metal sheet for the rear surface support material 6, it is possible to prevent an insulation failure between the photovoltaic cell 2 and rear surface support material 6, even when the rear surface sealing material 5 becomes thin in the periphery of the through hole 8.

Also, according to the photovoltaic module 1 according to this embodiment, since the width w₁ of the insulating material 10 is two times or more larger than the through hole diameter of the through hole 8, insulation is ensured by the insulating material 10 being reliably interposed between the photovoltaic cell 2 and rear surface support material 6, even when the rear surface sealing material 5 melts when laminate molding.

Also, according to the photovoltaic module 1 according to this embodiment, as the thickness t₃ of the insulating material 10 is a thickness within the range of 5µm to 1,000µm, it is also possible to carry out a release of air from between the rear surface sealing material 5 and insulating material 10 when laminate molding, while maintaining the insulating effect.

According to the photovoltaic module 1 according to this embodiment, since the laminate film wherein the front surface protective material 4 and front surface sealing material 3 are stacked one on the other and affixed is used for the insulating material 10, it is possible to manufacture the photovoltaic module 1 without causing a reduction in reliability. Also, as laminate molding is carried out with the insulating material 10 disposed between the photovoltaic cell 2 and rear surface sealing material 5 in the position of the through hole 8, there is no longer a danger of the rear surface sealing material 5 flowing into the through hole 8, and the end portion 2c of the photovoltaic cell 2 coming closer to the rear surface support material 6. Consequently, it is possible to further improve the electrical characteristics of the photovoltaic module 1.

Although a description has heretofore been given of embodiments of the invention, the invention is not limited to the heretofore described embodiments, with various kinds of modification and change being possible based on the technical idea of the invention.

### Description of Reference Numerals and Signs

- 1: Photovoltaic module
- 2: Photovoltaic cell
- 3: Front surface sealing material
- 4: Front surface protective material
- 5: Rear surface sealing material
- 6: Rear surface support material
- 7: Electric output wire
- 8: Through hole
- 9: Through hole sealing material
- 10: Insulating material
- 12: Insulating film sealing material
- 13: Fluoride resin
- 14A, 14B: Fluoride resin adhesive tape

## Claims

1. A photovoltaic module configured so that at least a first sealing material and a rear surface support material are stacked in that order on one surface side of a photovoltaic cell, a through hole is provided in the rear surface support material, and the electric output of the photovoltaic cell is output to the exterior by an electric output wire of the photovoltaic cell being passed through the through hole,
the module being **characterized in that** an insulating material is disposed between the photovoltaic cell and the first sealing material in a position corresponding to the through hole.

2. The photovoltaic module according to claim 1, **characterized in that** the insulating material is formed of a fluoride resin.

3. The photovoltaic module according to claim 1, **characterized in that** the insulating material is configured of a fluoride resin and a second sealing material, the fluoride resin is disposed between the first sealing material and the second sealing material, and the second sealing material is affixed to the photovoltaic cell.

4. The photovoltaic module according to any one of claims 1 to 3, **characterized in that** the photovoltaic cell, the first sealing material, the insulating material, and the rear surface support material are affixed by a laminate molding.

5. The photovoltaic module according to any one of claims 1 to 4, **characterized in that** the width of the insulating material is two times or more larger than the through hole diameter of the through hole.

6. The photovoltaic module according to any one of claims 1 to 5, **characterized in that** the thickness of the insulating material is a thickness within a range of 5µm to 1,000µm.

7. A manufacturing method of a photovoltaic module configured so that at least a first sealing material and a rear surface support material are stacked in that order on one surface side of a photovoltaic cell, a through hole is provided in the rear surface support material, and the electric output of the photovoltaic cell is output to the exterior by an electric output wire of the photovoltaic cell being passed through the through hole,
the photovoltaic module manufacturing method being **characterized by** including:
disposing an insulating material between the photovoltaic cell and the first sealing material in a position corresponding to the through hole; and
affixing the photovoltaic cell, the insulating material, the first sealing material, and the rear surface support material by a laminate molding.

8. The photovoltaic module manufacturing method according to claim 7, **characterized in that** the insulating material is formed of a fluoride resin.

9. The photovoltaic module manufacturing method according to claim 7, **characterized in that** the insulating material is configured of a fluoride resin and a second sealing material, the method further comprising:
disposing the fluoride resin between the first sealing material and the second sealing material; and
affixing the second sealing material to the photovoltaic cell.

10. The photovoltaic module manufacturing method according to any one of claims 7 to 9, **characterized in that** the width of the insulating material is two times or more larger than the through hole diameter of the through hole.

11. The photovoltaic module manufacturing method according to any one of claims 7 to 10, **characterized in that** the thickness of the insulating material is a thickness within a range of 5µm to 1,000µm.

## Amended claims

### Amended claims under Art. 19.1 PCT

**1.** A photovoltaic module configured so that at least a first sealing material and a rear surface support material are stacked in that order on one surface side of a photovoltaic cell, a through hole is provided in the rear surface support material, and the electric output of the photovoltaic cell is output to the exterior by an electric output wire of the photovoltaic cell being passed through the through hole,
the module being **characterized in that** an insulating material is disposed between the photovoltaic cell and the first sealing material in a position corresponding to the through hole.

**2.** The photovoltaic module according to claim 1, **characterized in that** the insulating material is formed of a fluoride resin.

**3.** The photovoltaic module according to claim 1, **characterized in that** the insulating material is configured of a fluoride resin and a second sealing material, the fluoride resin is disposed between the first sealing material and the second sealing material, and the second sealing material is affixed to the photovoltaic cell.

**4.** The photovoltaic module according to any one of claims 1 to 3, **characterized in that** the photovoltaic cell, the first sealing material, the insulating material, and the rear surface support material are affixed by a laminate molding.

**5.** The photovoltaic module according to any one of claims 1 to 4, **characterized in that** the width of the insulating material is two times or more larger than the through hole diameter of the through hole.

**6.** The photovoltaic module according to any one of claims 1 to 5, **characterized in that** the thickness of the insulating material is a thickness within a range of 5µm to 1,000µm.

**7.** (Amended) The photovoltaic module according to any one of claims 1 to 6, **characterized in that** a through hole sealing material for sealing the through hole is disposed in the through hole, and the thickness of the through hole sealing material is within a range from a thickness the same as the thickness of the rear surface support material to 1.5 times the thickness of the rear surface support material.

**8.** (Amended) The photovoltaic module according to claim 7, **characterized in that** the diameter of the through hole sealing material is within a range from a length the same as that of the diameter of the through hole to a length 1mm less than that of the diameter of the through hole.

**9.** (Amended) A manufacturing method of a photovoltaic module configured so that at least a first sealing material and a rear surface support material are stacked in that order on one surface side of a photovoltaic cell, a through hole is provided in the rear surface support material, and the electric output of the photovoltaic cell is output to the exterior by an electric output wire of the photovoltaic cell being passed through the through hole,
the photovoltaic module manufacturing method being **characterized by** including:
disposing an insulating material between the photovoltaic cell and the first sealing material in a position corresponding to the through hole; and
affixing the photovoltaic cell, the insulating material, the first sealing material, and the rear surface support material by a laminate molding.

**10.** (Amended) The photovoltaic module manufacturing method according to claim 9, **characterized in that** the insulating material is formed of a fluoride resin.

**11.** The photovoltaic module manufacturing method according to claim 9, **characterized in that** the insulating material is configured of a fluoride resin and a second sealing material, the method further comprising:
disposing the fluoride resin between the first sealing material and the second sealing material; and
affixing the second sealing material to the photovoltaic cell.

**12.** (Added) The photovoltaic module manufacturing method according to any one of claims 9 to 11, **characterized in that** the width of the insulating material is two times or more larger than the through hole diameter of the through hole.

**13.** (Added) The photovoltaic module manufacturing method according to any one of claims 9 to 12, **characterized in that** the thickness of the insulating material is a thickness within a range of 5µm to 1,000µm.

**14.** (Added) The photovoltaic module manufacturing method according to any one of claims 9 to 13, **characterized by** further comprising:
disposing a through hole sealing material in the through hole, wherein
the thickness of the through hole sealing material is within a range from a thickness the same as the thickness of the rear surface support material to 1.5 times the thickness of the rear surface support material.

**15.** (Added) The photovoltaic module manufacturing method according to claim 14, **characterized in that** the diameter of the through hole sealing material is within a range from a length the same as that of the diameter of the through hole to a length 1mm less than that of the diameter of the through hole.
